# EUROPÄISCHE PATENTSCHRIFT

(11) **EP 3 184 500 B1**
(45) Veröffentlichungstag und Bekanntmachung des Hinweises auf die Patenterteilung: **07.02.2024**
(21) Anmeldenummer: 16205642.8
(22) Anmeldetag: 21.12.2016
(51) Int. Cl.: C04B 37/02, H05K 3/46

(54) **HERSTELLUNGSVERFAHREN EINES METALL-KERAMIK-SUBSTRATES MIT VERBESSERTER FLÄCHEN-NUTZUNG**
METHOD OF MANUFACTURING A METAL-CERAMIC SUBSTRATE WITH IMPROVED SURFACE USE
PROCÉDÉ DE FABRICATION D'UN SUBSTRAT EN CÉRAMIQUE/MÉTAL PRÉSENTANT UNE UTILISATION DE SURFACE AMÉLIORÉE

(30) Priorität: 22.12.2015 EP 15201891
(43) Veröffentlichungstag der Anmeldung: 28.06.2017
(73) Patentinhaber: Heraeus Electronics GmbH & Co. KG, 63450 Hanau (DE)
(72) Erfinder: WACKER, Richard, 96135 Stegaurach (DE); ROGG, Alexander, 92724 Trabitz (DE)
(74) Vertreter: Gille Hrabal Partnerschaftsgesellschaft mbB Patentanwälte

(56) Entgegenhaltungen:
- EP-A1- 2 861 046
- WO-A1-2004/002204
- DE-A1-102012 102 787
- US-A1- 2012 119 349

## Beschreibung

Die vorliegende Erfindung betrifft ein Metall-Keramik-Substrat, welches in einem speziellen Verfahren zur Strukturierung der Metallbeschichtung verwendet werden kann. Des Weiteren betrifft die vorliegende Erfindung ein Verfahren zur Herstellung von strukturierten Metall-Keramik-Substraten.

Üblicherweise werden Metall-Keramik-Substrate, wie DCB-Substrate, mittels Fotolithographie strukturiert. Hierbei wird zunächst eine lichtempfindliche Folie (auch als Trockenfilm, Trockenresist, Fotoresist oder Laminat bezeichnet) auf die Metallbeschichtung aufgebracht (laminiert) und mit einem fotografischen Negativ (Film) abgedeckt. Anschließend werden mit einer starken Lichtquelle alle Bereiche des Laminats belichtet, die nicht durch den Film abgedeckt, d.h. verdunkelt sind. Die abgedeckten und unbelichteten Bereiche werden im nachfolgenden Entwicklungsschritt herausgelöst. Eine umgekehrte Verfahrensweise ist ebenfalls möglich. Das darunterliegende Kupfer wird dadurch freigelegt und in einem weiteren folgenden Verfahrensschritt durch Ätzen herausgelöst und somit entfernt.

Die Strukturierung von Metall-Keramik-Substraten erfolgt dabei üblicherweise durch Belichtung in automatischen Durchlaufbelichtern. Zu diesem Zweck werden die mit Metallbeschichtungen versehenen Substrate in einem Belichtungsraum auf einen Film abgelegt, der die Struktur der Substrat-Rückseite erzeugt.

Diese bekannte Verfahrensweise der Strukturierung von Metall-Keramik-Substraten weist einige Nachteile auf.

So besteht zum einen das Problem der Positionsgenauigkeit zwischen Substrat und Film während der Belichtung. Bei den Verfahren des Standes der Technik erfolgt derzeit vor dem Einbringen der Substrate in den Belichtungsraum des automatischen Durchlaufbelichters eine Vorpositionierung. Allerdings verschlechtert sich durch das Überführen der vorpositionierten Substrate in den Belichtungsraum und deren Ablegen die relative Positionsgenauigkeit von Film zu Substrat, wodurch sich Fehler im Millimeterbereich ergeben können. Alternativ können die Substrate während des Belichtens auch mechanisch angeschlagen und so positioniert werden. Nachteilig hierbei ist, dass die mechanischen Anschlagsysteme zu Abschattungen im Belichtungsprozess und somit zu einem Flächenverlust auf den Substraten führen können. Des Weiteren besteht der Nachteil, dass sich die Ungenauigkeiten von Film zu Anschlag und Anschlag zu Substrat aufsummieren und somit ebenfalls ein hochpräzises Positionieren von Substrat zu Layout nicht möglich ist.

Ein weiterer Nachteil der herkömmlichen Verfahren zur Strukturierung von Metall-Keramik-Substraten mittels der Fotolithographie ist der recht hohe Energiebedarf, da zur Strukturierung der gesamte Belichtungsraum beleuchtet werden muss.

Die Verwendung von konventionellen Filmen zur Belichtung ist darüber hinaus nachteilig, da entsprechende Filme zunächst einmal hergestellt werden müssen und eine Kontrolle der Maßhaltigkeit der Filme vor jeder Anwendung erforderlich ist. Weitere Probleme sind der Verschleiß der Filme, der im Extremfall zu Belichtungsfehlern führen kann, die Lagerhaltung bzw. Entsorgung sowie die Werkzeugverwaltung.

Schließlich sind die herkömmlichen Verfahren des Standes der Technik im Hinblick auf die Verfahrensökonomie, d.h. den Durchsatz, nachteilig. Die Herstellung von erforderlichen Filmen kann bis zu einigen Arbeitstagen dauern und der Wechsel von unterschiedlichen Layouts in entsprechenden Belichtungsprozessen ist mit dem Austausch des Films verbunden, was ebenfalls zu einer nachteiligen Prozessökonomie führt.

Die vorliegende Erfindung stellt sich nun insbesondere die Aufgabe, diese Nachteile des Standes der Technik zu lösen.

Erfindungsgemäß wird hierzu die Verwendung eines Direktbelichtungssystems empfohlen, das auf die Verwendung eines Films verzichtet und das Licht nur auf die zu belichteten Stellen des Metall-Keramik-Substrats projiziert. Direktbelichtungsverfahren benötigen im Gegensatz zu den bekannten Verfahren zur Strukturierung von Metall-Keramik-Substraten keinen Film zum Aufbringen des Layouts auf die lichtempfindliche Schicht. Vielmehr projizieren sie das Layout mittels Laser oder Projektoren direkt auf die lichtempfindliche Schicht des Metall-Keramik-Substrats. Dabei weisen herkömmliche, auf dem Markt erhältliche Vorrichtungen zur Direktbelichtung ein Bildverarbeitungssystem auf, welches die Position des zu strukturierenden Substrats in der Belichtungskammer erkennt und die Erstellung des Layouts auf dem Substrat an dessen Position anpassen kann.

Ein entsprechendes Direktbelichtungssystem ist beispielsweise in der deutschen Patentanmeldung DE 10 2009 032 210 A beschrieben, aus welcher eine Vorrichtung bekannt ist, die eine Belichtungseinrichtung und einen Objektträger in einer Belichtungskammer aufweist. Die Belichtungseinrichtung sowie der Objektträger sind zueinander beweglich angeordnet. Auf dem Objektträger ist ein plattenförmiges Substrat mit einer fotosensitiven Schicht vorgesehen, wobei die Position des Objekts in der Belichtungskammer anhand dessen Kante bestimmt wird. Basierend auf dieser durch die Kanten ermittelten Position des Substrats in der Belichtungskammer wird dann durch Belichtung ein Layout erzeugt.

Eine entsprechende Verfahrensweise ist bisher an Metall-Keramik-Substraten nicht vorgenommen worden, da die aus dem Stand der Technik bekannten Metall-Keramik-Substrate für eine derartige Anwendung in einem der DE 10 2009 032 210 A ähnlichem Direktbelichtungsverfahren ungeeignet sind.

Entsprechende Metall-Keramik-Substrate müssen nämlich die Eignung aufweisen, dass deren Position in einer Belichtungskammer, beispielsweise anhand der Kante des Metall-Keramik-Substrats, identifiziert werden kann und darüber hinaus nur eine geringe Durchbiegung bzw. eine geringe Ebenheit aufweisen, da andernfalls eine Direktbelichtung zu einer Ungenauigkeit des Layouts führen würde.

WO 2004/002204 A offenart ein Metall-Keramik-Substrat, bei welchem auf einem rechteckigen Keramik-Substrat mindestens eine Metallschicht vorgesehen ist. Das Keramik-Substrat ist zumindest teilweise im Kantenbereich frei von metallischer Beschichtung.

### Erfindungsgemäßes Metall-Keramik-Substrat

Der vorliegenden Erfindung liegt damit zunächst einmal die Aufgabe zu Grunde, ein Metall-Keramik-Substrat zur Verfügung zu stellen, welches geeignet ist, in einem Direktbelichtungsverfahren strukturiert zu werden.

Gelöst wird diese Aufgabe durch ein Metall-Keramik-Substrat, bei welchem auf einem im Wesentlichen rechteckigen Keramik-Substrat mindestens eine Metallschicht vorgesehen ist, wobei das Keramik-Substrat zumindest teilweise im Kantenbereich frei von metallischer Beschichtung ist, flächig ausgebildet ist und die darauf vorgesehene flächige Metallschicht sich zumindest teilweise nicht bis zur Kante des flächigen Keramik-Substrats erstreckt und somit zumindest der teilweise metallfreier Kantenbereich gebildet wird und der Kantenbereich, der frei von einer Metallisierung ist, sich lateral bis zu einer gedachten Parallelen zu der Keramikkante erstreckt, wobei der Abstand der gedachten Parallelen zu der Keramikkante maximal 1,5 cm beträgt, dadurch gekennzeichnet, dass das Metall-Keramik-Substrat ein DCB-Substrat ist und eine Ebenheit von kleiner als 1600 µm aufweist, wobei unter der Ebenheit des Metall-Keramik-Substrats eine Formtoleranz des Metall-Keramik-Substrats verstanden wird, in der sich die ebene Fläche des Metall-Keramik-Substrats befinden muss, die Toleranzgrenzen sich durch zwei gedachte Flächen parallel zur ideal planaren Fläche des Metall-Keramik-Substrats ergeben, wobei in dem Fall, in welchem die real erzeugte Fläche des Metall-Keramik-Substrats durch die eine der parallelen Flächen durchsticht, die Toleranz überschritten ist und die Toleranz den Abstand der beiden gedachten parallelen Flächen angibt und wobei die Fläche des Keramik-Substrats 5 x 10 cm bis 16 x 21 cm beträgt.

In einer bevorzugten Ausführungsform ist das erfindungsgemäße Metall-Keramik-Substrat zusätzlich dadurch gekennzeichnet, dass die Ebenheit des Metall-Keramik-Substrats kleiner 1400 µm, noch weiter bevorzugt kleiner 1200 µm, noch weiter bevorzugt kleiner 1000 µm, noch weiter bevorzugt kleiner 800 µm, noch weiter bevorzugt kleiner 500 µm, noch weiter bevorzugt kleiner 200 µm, ist.

Die erfindungsgemäße Voraussetzung eines metallfreien Kantenbereichs des Keramik-Substrats (Voraussetzung a.) ermöglicht eine genaue Positionsbestimmung des zu strukturierenden Metall-Keramik-Substrats in der Belichtungskammer anhand der metallfreien Kante bzw. einiger Punkte, die sich an der metallfreien Kante befinden, während die erfindungsgemäße Voraussetzung der Ebenheit (Voraussetzung b.) es ermöglicht, ein genaues Layout der Strukturierung auf dem Metall-Keramik-Substrat mittels der Direktbelichtung zu erzielen.

Der Kantenbereich, der im Rahmen der vorliegenden Erfindung frei von einer Metallisierung ist, erstreckt sich lateral bis zu einer gedachten Parallelen zu der Keramikkante, wobei der Abstand der Parallelen zu der Keramikkante vorzugsweise maximal 1,4 cm, weiter vorzugsweise maximal 1,3 cm, weiter vorzugsweise 1,2 cm, weiter vorzugsweise 1,1 cm, weiter vorzugsweise 1,0 cm, weiter vorzugsweise 0,9 cm, weiter vorzugsweise 0,8 cm, weiter vorzugsweise 0,7 cm, weiter vorzugsweise 0,6 cm, weiter vorzugsweise 0,5 cm, weiter vorzugsweise 0,4 cm, weiter vorzugsweise 0,3 cm, weiter vorzugsweise 0,2 cm, weiter vorzugsweise 0,1 cm, ist.

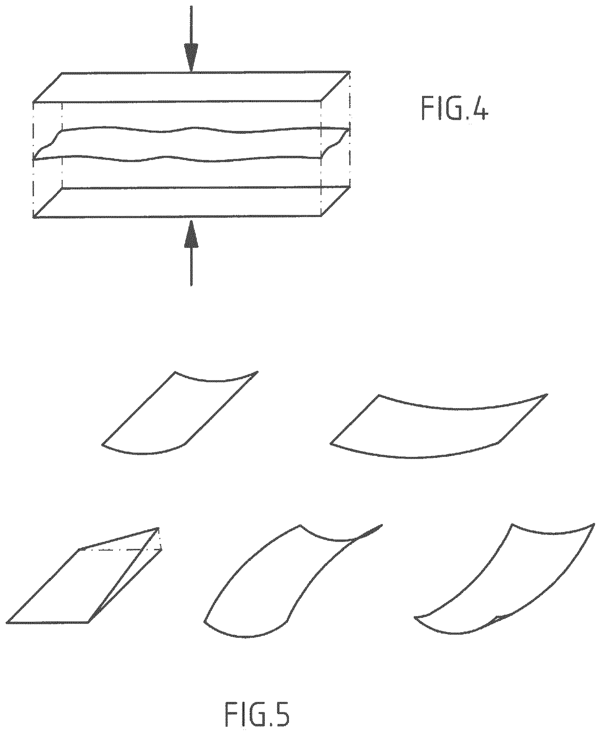

Unter einer Ebenheit des Metall-Keramik-Substrats wird im Rahmen der vorliegenden Erfindung eine Formtoleranz des Metall-Keramik-Substrats verstanden, in der sich die ebene Fläche des Metall-Keramik-Substrats befinden muss. Die Toleranzgrenzen ergeben sich durch zwei gedachte Flächen, parallel zur ideal planaren Fläche des Metall-Keramik-Substrats, wobei in dem Fall, in welchem die real erzeugte Fläche des Metall-Keramik-Substrats durch die eine der parallelen Flächen durchsticht, die Toleranz überschritten ist. Die Toleranz gibt den Abstand der beiden gedachten parallelen Flächen an. Eine entsprechende Anordnung zur erfindungsgemäßen Definition der Ebenheit ist in der Fig. 4 dargestellt, wobei das Metall-Keramik-Substrat 1 zwischen zwei ideal ebene parallel verlaufende gedachte Flächen 10 und 11 positioniert wird. Diese strukturellen Voraussetzungen eines Metall-Keramik-Substrats sind aus dem Stand der Technik DE 10 2009 032 210 A für die dort zu strukturierenden plattenförmigen Objekte nicht bekannt, da der Stand der Technik DE 10 2009 032 210 A nicht auf eine Strukturierung von Metall-Keramik-Substraten abzielt, sondern auf die Strukturierung von PCB-Leiterplatten.

Bei PCB-Leiterplatten werden im Allgemeinen geringe Dicken der Metallbeschichtung im Allgemeinen in einem Bereich von 12 bis 100 µm realisiert, während die erfindungsgemäß zu verwendenden Metall-Keramik-Substrate Schichtdicken der Metallisierung von im Allgemeinen 200 bis 600 µm aufweisen. Aufgrund der höheren Dicke der Metallbeschichtung und der damit verbundenen Erwartung, dass entsprechende Metall-Keramik-Substrate keine ausreichende Ebenheit aufweisen, hätte der Fachmann eine Übertragung der Lehre der DE 10 2009 032 210 A auf Metall-Keramik-Substrate nicht in Betracht gezogen. Mögliche Durchbiegungsrichtungen von Metall-Keramik-Substraten sind beispielhaft in der Figur 5 dargestellt, wobei die Figur 5aqeine mögliche Querbiegung und Figur 5b eine mögliche Längsbiegung des Metall-Keramik-Substrats zeigt. Die Figuren 5c bis 5e zeigen als Durchbiegungsformen des Metall-Keramik-Substrats eine Torsion, einen Sattel und eine Kalotte. Hinzukommend sind auch Mischformen denkbar.

Neben den dargestellten Durchbiegungen von Metall-Keramik-Substraten sind auch weitere beispielsweise wellenförmige Durchbiegungsformen denkbar. Für diese Durchbiegungen ist neben der Schichtdicke der Metallbeschichtung auch die Dicke der verwendeten Keramiksubstrate verantwortlich. Auch durch die Herstellung der entsprechenden Metall-Keramik-Substrate, d.h. die Art und Weise wie das Keramiksubstrat gebondet wird, sowie nachgelagerte Bearbeitungsprozesse können entsprechende Einflüsse auf die Durchbiegung haben. Schließlich sind weitere Einflussparameter die Zusammensetzungen von Keramiksubstrat und Metallbeschichtung.

Diese immanenten Eigenschaften unterscheiden die Metall-Keramik-Substrate eindeutig von PCB-Leiterplatten, die im Hinblick auf Krümmungsradius sowie Härte, Festigkeit, Elastizität und Federkraft deutlich unkritischer als Metall-Keramik-Substrate sind.

Eine weitere Überlegung, die den Fachmann davon abgehalten hätte, die in der DE 10 2009 032 210 A beschriebene technische Lehre auch auf Metall-Keramik-Substrate anzuwenden, ist die geringere Flächengröße der Metall-Keramik-Substrate im Vergleich zu der Flächengröße der üblicherweise verendeten PCB-Leiterplatten, die üblicherweise in Größen von 26 x 24 Zoll (650 x 610 mm) vorliegen.

Eine weitere Überlegung, die den Fachmann von der Übertragung der Lehre der DE 10 2009 032 210 A auf Metall-Keramik-Substrate abgehalten hätte, ist der üblicherweise bei Metall-Keramik-Substraten auftretende schräge Kantenverlauf, der insbesondere bei beidseitig zu strukturierenden Metall-Keramik-Substraten eine genaue Kantenerkennung und genaue Positionierung des Layouts der Strukturierung (auf beide Seiten des Metall-Keramik-Substrats abgestimmt) verkompliziert.

Darüber hinaus beschreibt die DE 10 2009 032 210 A eine Kantenerfassung auf einem rotierenden Wafer, was im Rahmen der vorliegenden Erfindung nicht vorgesehen ist.

Wesentlich bei dem weiter unten beschriebenen erfindungsgemäßen Verfahren ist, dass die Position des Metall-Keramik-Substrats in der Belichtungskammer anhand von metallfreien Kanten bzw. metallfreien Punkte an den Kanten des Keramiksubstrats bestimmt wird.

Im Rahmen der vorliegenden Erfindung werden dabei die folgenden Begrifflichkeiten verwendet:
- Bezugskante und Bezugspunkt:: Die Position des Metall-Keramik-Substrats wird anhand der Lage einer metallfreien Kante des im Wesentlichen rechteckigen Substrats (Bezugskante) und der Lage eines weiteren metallfreien Punkts (Bezugspunkt) an einer Kante im Wesentlichen senkrecht zu der Bezugskante bestimmt.
- Referenzpunkte:: Die Bezugskante kann auch nicht vollständig metallfrei ausgebildet sein. In diesem Fall muss die Bezugskante mit Hilfe der Lage von mindestens zwei Referenzpunkten bestimmt werden, die sich in metallfreien Bereichen an einer Kante des Keramiksubstrats befinden. Die Bezugskante wird dann durch Verbinden der beiden Referenzpunkte definiert.

Im Folgenden werden die erfindungsgemäßen Metall-Keramik-Substrate, die als Ausgangsmaterialien in einem weiter unten beschriebenen erfindungsgemäßen Verfahren zur Strukturierung verwendet werden, näher beschrieben.

### Erfindungsgemäße Voraussetzung der metallfreien Kante des Keramik-Substrats:

Entsprechende Vorrichtungen zur Direktbelichtung von Substraten sind kommerziell erhältlich, auch wenn diese bisher nur zur Strukturierung von beispielsweise PCB-Leiterplatten verwendet wurden.

Diese Vorrichtungen sind in der Lage, die Position des Substrats, d.h. auch eines Metall-Keramik-Substrats, in der Belichtungskammer zu erkennen und können mit Hilfe der Koordinatentransformation eine Ausrichtung des Layouts an die genaue Position des Metall-Keramik-Substrats sicherstellen. Hierzu müssen definierte Stellen des Metall-Keramik-Substrats in der Belichtungskammer durch ein Bildverarbeitungssystem erfasst werden.

Als definierte Stellen können beispielsweise die Kanten eines Metall-Keramik-Substrats verwendet werden. Allerdings stört eine Metallbeschichtung in diesem Kantenbereich eine Erfassung, so dass das Keramik-Substrat gemäß der Voraussetzung a. zumindest teilweise im Kantenbereich metallfrei sein muss.

Daher ist das Keramik-Substrat vorzugsweise so ausgebildet, dass es zumindest einigen Stellen im Kantenbereich keine Metallbeschichtung aufweist.

Die Anzahl an metallfreien Stellen im Kantenbereich des Keramik-Substrats kann im Rahmen der vorliegenden Erfindung variieren, so lange sichergestellt ist, dass eine ausreichende Genauigkeit bei der Positionserfassung des Metall-Keramik-Substrats in der Belichtungskammer gegeben ist.

Die erfindungsgemäß zu strukturierenden Metall-Keramik-Substrate können eine verhältnismäßig kleine Fläche aufweisen. Bei kleinen zu strukturierenden Metallflächen auf dem Keramiksubstrat ist eine optimale Raumausnutzung von Vorteil. Die metallfreien Flächen entlang den Kanten des Keramiksubstrates sollten daher möglichst klein gewählt werden, um eine ausreichende Fläche für eine Strukturierung zur Verfügung zu haben, und andererseits groß genug sein, dass eine effiziente Positionserkennung möglich ist.

Daher ist es bevorzugt, dass in dem erfindungsgemäßen Metall-Keramik-Substrat zumindest an den Stellen, an denen eine Positionsbestimmung erfolgt, in dem entsprechenden Kantenbereich die Metallbeschichtung im Wesentlichen parallel zur Keramikkante rückversetzt verläuft und ein Abstand der Metallkante der Metallbeschichtung von der Keramikkante von mindestens 0,1 cm, weiter bevorzugt mindestens 0,2 cm, noch weiter bevorzugt mindestens 0,3 cm, aufweist. Dieser Abstand der Metallbeschichtung von der Kante des Keramik-Substrats kann vorliegen, wenn nur Teilbereiche der Kante metallfrei ausgebildet sind oder die gesamte Kante der Keramik-Substrats metallfrei ausgebildet ist (vgl. hierzu die weiter unten beschriebenen Ausführungsformen).

Darüber hinaus ist es des Weiteren bevorzugt, wenn zumindest an den Stellen des Kantenbereichs, an denen eine Positionsbestimmung erfolgt, die Metallbeschichtung im Wesentlichen parallel zur Keramikkante verläuft und die Metallkante der Metallbeschichtung einen Abstand von höchstens 0,8 cm, weiter bevorzugt mindestens 0,7 cm, noch weiter bevorzugt mindestens 0,6 cm, von der Keramikkante aufweist.

Größere Abstände der Metallkante von der Keramikkante sind im Hinblick auf die Flächenausnutzung nachteilig, während kleinere Abstände der Metallkante von der Keramikkante zu einer ungenauen Positionserkennung in der Belichtungskammer führen.

Grundsätzlich gibt es mehrere Möglichkeiten, die Position eines Metall-Keramik-Substrats in einer Belichtungskammer anhand von definierten Stellen des Metall-Keramik-Substrats zu bestimmen.

Unter der Annahme, dass das zu strukturierende Metall-Keramik-Substrat in der Belichtungskammer auf einem ebenen Objektträger liegt und senkrecht von oben zum einen die Positionsbestimmung als auch die Strukturierung des Metall-Keramik-Substrats erfolgt, ist die Lageerfassung von mindestens 3 Punkten des Metall-Keramik-Substrats erforderlich, um dessen genaue Position und dessen Verdrehung in der Ebene zu beschreiben.

Im Folgenden werden nun Ausgestaltungen des Metall-Keramik-Substrats beschrieben, die für eine Positionsbestimmung des Metall-Keramik-Substrats in der Belichtungskammer entweder erforderlich oder aber bevorzugt sind.

### Erste Ausführungsform:

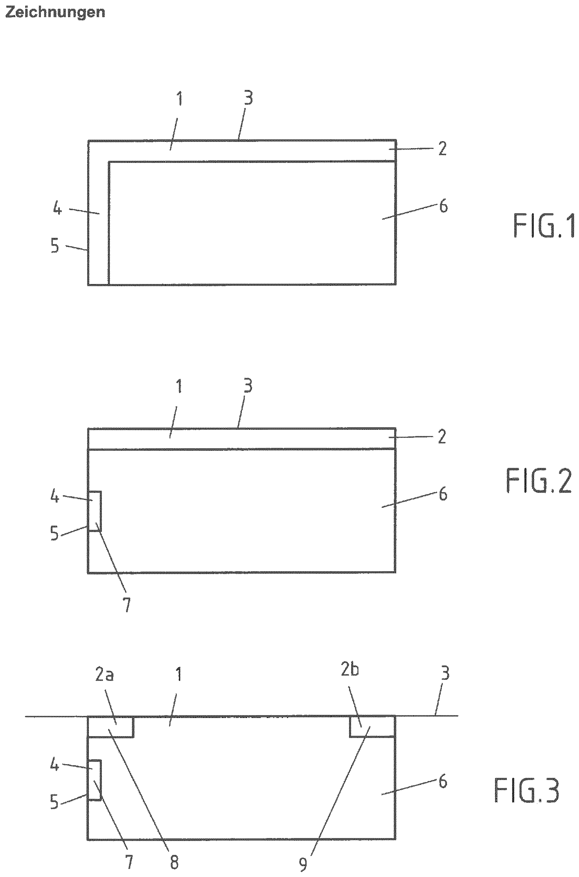

In einer ersten Ausführungsform erfolgt die Positionsbestimmung des Metall-Keramik-Substrats 1 in der Belichtungskammer durch die Erfassung von zwei Bezugskanten 3 und 5, die im Wesentlichen senkrecht zueinander stehen. In dieser Ausführungsform sind also die zwei im Wesentlichen senkrecht zueinander angeordneten Bezugskanten 3 und 5 des Keramik-Substrats metallfrei ausgebildet. Diese erste Ausführungsform des Metall-Keramik-Substrats 1 ist in der Figur 1 dargestellt. Dabei weisen die Bezugsziffern die folgende Bedeutung auf:
1: Metall-Keramik-Substrat
2: metallfreier Kantenbereich der Bezugskante 3
3: Bezugskante
4: metallfreier Bereich der Bezugskante 5
5: Bezugskante
6: Metallbeschichtung

In dieser ersten Ausführungsform können die verbleibenden Kanten des Keramik-Substrats ebenfalls metallfrei oder nicht metallfrei ausgebildet sein. Unter dem Gesichtspunkt einer möglichst optimalen Flächennutzung für die Strukturierung ist eine Ausgestaltung bevorzugt, bei welchem die verbleibenden Kantenbereiche nicht metallfrei ausgebildet sind.

Wenn im Rahmen der vorliegenden Erfindung zwei metallfreie Kantenbereiche senkrecht zueinander angeordnet sind, so können die Ecken, an denen die senkrechten Kanten aufeinander stoßen, trotzdem abgerundet sein.

### Zweite Ausführungsform

In einer zweiten Ausführungsform erfolgt die Positionsbestimmung des Metall-Keramik-Substrats 1 in der Belichtungskammer durch die Erfassung von einer vollständig metallfreien Bezugskante 3 und eines Punktes auf der Bezugskante 5, die im Wesentlichen senkrecht zu der Bezugskante 3 verläuft. Dieser Punkt auf der Bezugskante 5 senkrecht zu der Bezugskante 3 wird im Rahmen der vorliegenden Erfindung als Bezugspunkt 7 bezeichnet. Diese zweite Ausführungsform des Metall-Keramik-Substrats 1 ist in der Figur 2 dargestellt. Dabei ist die Bezugskante 3 vollständig, d.h. durchgehend, metallfrei ausgebildet und die Bezugskante 5 senkrecht zu der Bezugskante 3 weist einen Teilbereich 4 auf, der ebenfalls metallfrei ausgebildet ist und in welchem der Bezugspunkt 7 liegt. Die Bezugsziffern in Figur 2 weisen die folgende Bedeutung auf:
1: Metall-Keramik-Substrat
2: metallfreier Kantenbereich der Bezugskante 3
3: Bezugskante
4: metallfreier Teilbereich an der Bezugskante 5
5: Bezugskante
6: Metallbeschichtung
7: Bezugspunkt im metallfreien Teilbereich 4 an der Bezugskante 5

Die Position des metallfreien Teilbereichs 4 um den Bezugspunkt 7 kann im Rahmen der vorliegenden Erfindung variieren, allerdings ist ein metallfreier Teilbereich 4 in der Mitte der Bezugskante 5 bevorzugt, um die Position des Metall-Keramik-Substrats 1 in der Belichtungskammer genau zu bestimmen. Bei der Verwendung eines metallfreien Bereichs 4 um den Bezugspunkt 7 in der Mitte der Bezugskante 5 wird ein möglicher Winkelfehler des Keramik-Substrats, d.h. eine Abweichung des Winkels von 90° zwischen den beiden Bezugskanten 3 und 5, auf ein Minimum reduziert. Darüber hinaus ist es auch möglich, dass der metallfreie Bereich 4 um den Bezugspunkt 5 nahe der Bezugskante 3 gelegt wird, wodurch der Bezugspunkt 5 und die Bezugskante 3 in diesem Bereich durch eine einzige gemeinsame Kamera erfasst werden kann. Hierdurch lässt sich die Anzahl an erforderlichen Kameras für die Bestimmung der Lage des Metall-Keramik-Substrats 1 in der Belichtungsammer reduzieren. In dieser zweiten Ausführungsform des erfindungsgemäßen Metall-Keramik-Substrats 1 ist die metallfreie Bezugskante 3 vorzugsweise diejenige Kante des Metall-Keramik-Substrats 1, welche die größte Länge aufweist, und der metallfreie Teilbereich 4 des Bezugspunkts 7 ist dann an der kürzeren Bezugskante 5 des Metall-Keramik-Substrats 1 vorgesehen.

### Dritte Ausführungsform

In einer dritten Ausführungsform erfolgt die Positionsbestimmung des Metall-Keramik-Substrats 1 in der Belichtungskammer durch die Erfassung von drei Punkten an zwei angrenzenden Kanten, wobei die angrenzenden Kanten im Wesentlichen senkrecht zueinander angeordnet sind. In diesem Fall wird zunächst die Lage von zwei Referenzpunkten 8 und 9 an einer Bezugskante 3 in zwei metallfreien Teilbereichen 2a und 2b der Bezugskante 3 identifiziert und die Lage der Bezugskante 3 in der Belichtungskammer durch diese beiden Referenzpunkte 8 und 9 bestimmt. Mit Hilfe des verbleibenden Bezugspunkts 7 an der senkrecht zu der ersten Bezugskante 3 angeordneten Bezugskante 5 kann dann die Position des Metall-Keramik-Substrats 1 in der Belichtungskammer bestimmt werden. Die beiden Referenzpunkte 8 und 9 liegen an einer Bezugskante 3 des Keramiksubstrats in jeweils metallfreien Teilbereichen2a und 2b. Diese dritte Ausführungsform des Metall-Keramik-Substrats ist in der Figur 3 dargestellt. Die Bezugsziffern weisen die folgende Bedeutung auf:
- 1:: Metall-Keramik-Substrat
- 2a, 2b:: teilweise metallfreie Bereiche der ersten Bezugskante
- 3:: Bezugskante
- 4:: metallfreier Teilbereich an der Bezugskante 5
- 5:: Bezugskante
- 6:: Metallbeschichtung
- 7:: Bezugspunkt im metallfreien Teilbereich 4 der Bezugskante 5
- 8:: Referenzpunkt an der Bezugskante 3
- 9:: Referenzpunkt an der Bezugskante 3

In dieser dritten Ausführungsform ist das Metall-Keramik-Substrat 1 daher so ausgebildet, dass es an der ersten Bezugskante 3 zwei metallfreie Teilbereiche 2a und 2b aufweist und an der Bezugskante 5, die senkrecht zu der Bezugskante 3 verläuft, einen weiteren metallfreien Teilbereich 4 aufweist. In dieser dritten Ausführungsform des erfindungsgemäßen Metall-Keramik-Substrats 1 ist die Bezugskante 3 mit den beiden metallfreien Teilbereichen 2a und 2b vorzugsweise diejenige Kante des Metall-Keramik-Substrats 1, welche die größte Länge aufweist, und der metallfreie Teilbereich 4 der Bezugskante 5 liegt an der kürzeren Kante des Metall-Keramik-Substrats 1. Diese Ausgestaltung ist in Figur 3 dargestellt. Bevorzugt ist in dieser Ausführungsform ferner, dass der Abstand der Referenzpunkte 8 und 9 mindestens 50 %, weiter bevorzugt mindestens 70 %, noch weiter bevorzugt mindestens 90 %, der Länge der Bezugskante 3 des Metall-Keramik-Substrats 1 beträgt. Besonders bevorzugt befinden sich die Referenzpunkte in den Ecken der Bezugskante 3 des Metall-Keramik-Substrats 1. Diese dritte Ausführungsform der vorliegenden Erfindung weist den Vorteil auf, dass die Bezugskante 3 nicht vollständig metallfrei ausgebildet sei muss und daher insgesamt mehr Fläche für die Strukturierung der Metallbeschichtung des Metall-Keramik-Substrats 1 zur Verfügung steht. Dieses spielt insbesondere bei relativ kleinen Metallflächen, wie sie beispielsweise bei DCB-Substraten auftreten, eine Rolle. In dieser dritten Ausführungsform ist es des Weiteren gegebenenfalls bevorzugt, dass der Bezugspunkt 7 auf der Bezugskante 5 gemeinsam mit dem benachbarten Referenzpunkt 8 der Bezugskante 3 durch eine einzige gemeinsame Kamera identifiziert wird. Daher kann der Bezugspunkt 7 nahe an dem Referenzpunkt 8 der Bezugskante 3 vorgesehen sein.

Die metallfreien Teilbereiche 2a und 2b weisen üblicherweise eine Größe von 20 bis 60 mm², weiter bevorzugt 30 bis 50 mm², noch weiter bevorzugt 35 bis 45 mm², auf.

Die oben beschriebenen ersten bis dritten Ausführungsformen definieren Metall-Keramik-Substrate mit den mindestens erforderlichen metallfreien Kantenbereichen. Darüber hinaus ist es aber auch möglich, weitere Teilbereiche der Keramikkanten metallfrei auszubilden und auch an diesen weiteren metallfreien Bereichen die Position des Metall-Keramik-Substrats zu bestimmen, um somit die Genauigkeit der Positionsbestimmung des Metall-Keramik-Substrats in der Belichtungskammer zu verbessern oder aber um weitere Informationen über die geometrische Ausdehnung des Metall-Keramik-Substrats zu erhalten. Hierfür bekommen insbesondere metallfreie Bereiche an den anderen Kanten des Metall-Keramik-Substrats in Frage.

Die oben beschriebenen ersten bis dritten Ausführungsformen sehen vor, dass einzelne Bezugspunkte an den metallfreien Kanten des Keramik-Substrats ermittelt werden. Dabei ist es in einer weiteren Ausgestaltung möglich, dass jeder einzelne Punkt aus mehreren Einzelpunkten errechnet wird. Durch die Erkennung einer Bezugskante wird die Verdrehung des Substrates in der x-y-Ebene, die durch das Metall-Keramik-Substrat aufgebaut wird, kompensiert.

Die entsprechend zu strukturierenden Metall-Keramik-Substrate der vorliegenden Erfindung werden vorzugsweise hergestellt durch Verfahren, die in den deutschen Patentanmeldungen DE 10 2014 215 377.8 und DE 10 2014 224 588.5 beschrieben sind. Demnach werden die erfindungsgemäß zu verwendenden Metall-Keramik-Substrate vorzugsweise nach einem Verfahren gemäß DE 10 2014 215 377.8 hergestellt, das durch die folgenden Verfahrensschritte gekennzeichnet ist:
(1) Positionieren von einer Anordnung, umfassend zumindest eine erste Metallschicht, zumindest eine zweite Metallschicht und ein zwischen der ersten und zweiten Metallschicht angeordnetem Keramik-Substrat, auf einem Träger;
(2) Erhitzen der aus dem Verfahrensschritt (1) resultierenden Anordnung auf eine Temperatur, so dass es zu einem Verbund aus dem Keramik-Substrat und den zwei anliegenden Metallschichten durch Bonden unter Ausbildung eines doppelseitig metallisierten Keramik-Substrats kommt,
wobei der Träger in Verfahrensschritt (1) vor dem Positionieren der Anordnung geneigt und/oder gewölbt ist und/oder der Träger in Verfahrensschritt (1) nach dem Positionieren der Anordnung auf dem Träger und/oder während dem Verfahrensschritt (2) geneigt wird.

In einer weiteren Ausgestaltung wird das erfindungsgemäß zu verwendende Metall-Keramik-Substrat durch ein Verfahren gemäß DE 10 2014 224 588.5, umfassend die folgenden Verfahrensschritte, hergestellt:
(1) Positionieren von einer Anordnung, umfassend zumindest eine erste Metallschicht und ein Keramik-Substrat, auf einem Träger;
(2) Erhitzen der aus dem Verfahrensschritt (1) resultierenden Anordnung auf eine Temperatur, so dass es zu einem Verbund aus dem Keramik-Substrat und der anliegenden zumindest einen Metallschicht durch Bonden unter Ausbildung eines metallisierten Keramik-Substrats kommt, wobei
   - der Träger in Verfahrensschritt (1) an mindestens einer seiner randseitigen Kanten mindestens eine Auflage aufweist, auf der die Anordnung aus Verfahrensschritt (1) in mindestens einem randseitigen Teilbereich der Anordnung mit mindestens einer ihrer Außenkanten aufliegt, und
   - die mindestens eine Auflage auf dem Träger so angeordnet ist, dass die Anordnung beim Positionieren auf der Auflage des Trägers geneigt ist und/oder
   - der Träger mit der mindestens einen Auflage in Verfahrensschritt (1) nach dem Positionieren der Anordnung auf der mindestens einen Auflage des Trägers und/oder während des Verfahrensschritt (2) geneigt wird,
   - und worin der Träger an mindestens einer seiner randseitigen Kanten mindestens eine Begrenzung in der Form von mindestens einem Anschlag oder mindestens einer Kante aufweist.

Die beispielsweise aus diesen Verfahren erhältlichen Metall-Keramik-Substrate werden dann so modifiziert, dass die entsprechenden Bereiche an den Bezugskanten metallfrei ausgebildet sind. Möglichkeiten die entsprechenden Bereiche an den bezugskanten metallfrei zu erhalten sind beispielsweise:
In einer ersten Ausgestaltung wird die Metallschicht ausreichend klein gestaltet und mittig auf die Keramik aufgelegt. In Abhängigkeit der produzierten Materialkombination kann die Metallschicht während des Bondens mehrere Millimeter durch die Neigung des Trägers verrutschen.

In einer zweiten Ausgestaltung wird die Metallschicht in den entsprechenden Kantenbereichen der Bilderkennung ausgestanzt und Metallschicht wird über ein Anschlagsystem während des Bondens zur Keramik ausgerichtet. Die Verfahrensweise eignet sich insbesondere bei der Herstellung von Metall-Keramik-Substraten mit den oben genannten Verfahren, die in der DE 10 2014 215 377.8 und DE 10 2014 224 588.5 beschrieben sind. Die Breite der Ausstanzung (parallel zur Keramikkante kann mehrere Millimeter, z. B. 5 bis 10mm, betragen. Eine größere Ausstanzung ist für die Bilderfassung nicht nötig und würde möglicherweise nutzbare Fläche reduzieren.

In einer dritten Ausgestaltung ist ein nachträgliches Entfernen der Metallschicht möglich, was jedoch technisch und wirtschaftlich nicht sinnvoll ist.

In einer vierten Ausgestaltung wird die Metallschicht so gestaltet, dass sie nach dem Bonden um mindestens 0,5 mm kleiner ist als die Keramik und wird während des Bondens auf der gegenüberliegenden Seite angeschlagen. Dadurch ergibt sich ein metallfreier Rand, der für die Bildverarbeitung verwendet werden kann. Die erfindungsgemäßen Metall-Keramik-Substrate sollen sich zur Anwendung der Strukturierung mittels Direktbelichtung eignen. Hierzu muss die Belichtung, die dem zu erzeugende Layout entspricht, an die Position des Metall-Keramik-Substrats in der Belichtungskammer angepasst werden. Die oben beschriebenen metallfreien Bereiche bzw. Teilbereiche der Kanten bzw. Punkte werden in der Belichtungskammer wie oben beschrieben durch eine oder mehrere Kameras erfasst und anschließend wird beispielsweise mittels Koordinatentransformation die Position des Metall-Keramik-Substrats und des Layouts aufeinander abgestimmt.

Derartige Verfahren sind im Bereich der Leiterplattenherstellung (PCB-Herstellung) Stand der Technik. Hierzu wird beispielsweise auf die DE 10 2009 032 210 A verwiesen.

Bei der Verwendung von keramischen Leiterplatten, beispielsweise von DCB-Substraten, gibt es jedoch im Vergleich zu der Lehre der DE 10 2009 032 210 A Besonderheiten, die dazu geführt haben, dass die Technologie der Strukturierung mittels Direktbelichtung bisher noch nicht auf Metall-Keramik-Substrate, insbesondere DCB-Substrate, übertragen wurde.

In dieser Hinsichtlich ist zunächst einmal die Maßhaltigkeit der keramischen Substrate hinsichtlich Länge und Breite zu nennen, die in technisch realisierten Verfahren in der Regel eine Schwankung um bis zu 1,5 % aufweisen. Weitere Schwierigkeiten ergeben sich durch die nicht vorhandene Winkeltreue der Kanten der verwendeten Keramiksubstrate zueinander, die teils deutlich von 90° abweicht, sowie die von einer idealen Ebenheit teilweise deutlich abweichenden Ebenheit der Keramiksubstrate, insbesondere im Kantenbereich, die erfindungsgemäß jedoch erforderlich ist.

Aus den bekannten Verfahren resultierende Keramiksubstrate weisen häufig gewölbte oder verbogene Kanten auf und können daher nicht mit Hilfe von optischen Kantenerfassungseinrichtungen ausreichend genau erfasst werden.

Daher ist es häufig erforderlich, die Keramikkanten vor dem Herstellungsschritt des Bondens der Metallbeschichtung auf dem Keramiksubstrat noch zu bearbeiten. Diese Bearbeitung der Metall-Keramik-Substrate kann an einer, zwei, drei oder an allen vier Kanten des Keramik-Substrats erforderlich sein, um eine ausreichende Maßhaltigkeit und Rechtwinkeligkeit sicherzustellen. Die Anzahl an zu bearbeitenden Kanten hängt von der Anzahl und Lage der erfassten metallfreien Kantenbereichen ab.

Erfindungsgemäß erforderliche exakte Keramikkanten für die Kantenerfassung können beispielsweise durch das Einbringen von Sollbruchlinien mittels Laser oder Diamant-Ritzen und dem anschließenden Abbrechen der Kanten erfolgen. Somit werden die Ungenauigkeiten der Kante entfernt, die während der Herstellung der Keramik-Substrate entstehen. Auf diese Weise können auch die Ungenauigkeiten der Außenabmessungen der Keramik-Substrate deutlich reduziert werden.

Im Rahmen der vorliegenden Erfindung werden insbesondere beidseitig metallisierter Keramiksubstrate verwendet, d.h. Keramik-Substrate die auf beiden Seiten eine zu strukturierenden Metallbeschichtung aufweisen.

Neben den metallfreien Kantenbereichen müssen die erfindungsgemäßen Metall-Keramik-Substrate auch noch zumindest eine weitere strukturelle Voraussetzung erfüllen, um mit Hilfe der Direktbelichtungstechnologie strukturiert zu werden.

### Erfindungsgemäße Voraussetzung der Ebenheit des Keramik-Substrats:

Die aus den üblichen Verfahren erhältlichen Metall-Keramik-Substrate weisen in der Regel keine ideal ebene Struktur auf. Diese Durchbiegung der Metall-Keramik-Substrate muss während des Belichtens so weit wie möglich reduziert werden, weil es andernfalls zu Fehlern bei der Bildverarbeitung bei der Kantenfindung (Unschärfe) und zu einer unscharfen Belichtung kommen kann.

Die erforderliche Ebenheit des Metall-Keramik-Substrats von kleiner 800 µm, weiter bevorzugt kleiner 500 µm, noch weiter bevorzugt kleiner 200 µm kann in einer ersten Ausführungsform beispielsweise dadurch erreicht werden, dass man das zu strukturierende Metall-Keramik-Substrat zwischen zwei transparente Platten, beispielsweise Glasplatten oder Folien, fixiert und dann belichtet.

In einer zweiten Ausführungsform kann man, um diese Durchbiegung zu reduzieren, die Keramiksubstrate mit Rahmen klemmen.

In einer dritten Ausführungsform der vorliegenden Erfindung können die Substrate mittels Vakuum angesaugt werden. Die erfindungsgemäße Ebenheit der Metall-Keramik-Substrate liegt insbesondere dann vor, wenn die Metall-Keramik-Substrate gemäß der ersten Ausführungsform zwischen zwei Glasplatten fixiert werden, gemäß der zweiten Ausführungsform mit Rahmen geklemmt werden oder gemäß der dritten Ausführungsform mittels Vakuum angesaugt werden.

Damit eine effizienten Kantenerkennung erfolgen kann, weist das erfindungsgemäße Metall-Keramik-Substrat des Weiteren eine Rauheit Ra von maximal 16 µm, weiter bevorzugt von maximal 13 µm, noch weiter bevorzugt von maximal 10 µm, auf. Eine entsprechende Rauheit kann beispielsweise durch eine Laserbearbeitung des metall-Keramik-Substrats erreicht werden.

Des Weiteren ist es bevorzugt, wenn die metallfreien Kanten bzw. Teilbereiche bei doppelseitig metallisierten Keramik-Substraten beidseitig vorliegen.

Im Fall von doppelseitig beschichteten Metall-Keramik-Substraten sind darüber hinaus noch die folgenden bevorzugten Ausgestaltungen zu nennen:
In dem Fall, dass das erfindungsgemäße Metall-Keramik-Substrat eine Keramikdicke von 0,38 cm aufweist, ist das Verhältnis der Metallbeschichtungsdicke von Vorderseite zu Rückseite vorzugsweise kleiner 2,5, weiter bevorzugt kleiner 2,25, noch weiter bevorzugt kleiner 2, ist. Dabei ist des Weiteren bevorzugt, dass der Unterschied der Metallbeschichtungen kleiner 200 µm, weiter bevorzugt kleiner 175 µm, noch weiter bevorzugt kleiner 150 µm, ist.

In dem Fall, dass das erfindungsgemäße Metall-Keramik-Substrat eine Keramikdicke von kleiner 0,38 cm aufweist, ist das Verhältnis der Metallbeschichtungsdicke von Vorderseite zu Rückseite vorzugsweise kleiner 2,0, weiter bevorzugt kleiner 1,75, noch weiter bevorzugt kleiner 1,5, ist. Dabei ist des Weiteren bevorzugt, dass der Unterschied der Metallbeschichtungen kleiner 150 µm, weiter bevorzugt kleiner 125 µm, noch weiter bevorzugt kleiner 100 µm, ist.

In dem Fall, dass das erfindungsgemäße Metall-Keramik-Substrat eine Keramikdicke von größer 0,38 cm aufweist, ist das Verhältnis der Metallbeschichtungsdicke von Vorderseite zu Rückseite vorzugsweise kleiner 3,0, weiter bevorzugt kleiner 2,75, noch weiter bevorzugt kleiner 2,5, ist. Dabei ist des Weiteren bevorzugt, dass der Unterschied der Metallbeschichtungen kleiner 300 µm, weiter bevorzugt kleiner 275 µm, noch weiter bevorzugt kleiner 250 µm, ist.

Insgesamt ist es bevorzugt, wenn der Unterschied der Metallbeschichtungen kleiner als 50 %, weiter bevorzugt kleiner als 45 %, noch weiter bevorzugt kleiner als 40 %, der Schichtdicke des Keramiksubstrats ist.

### Erfindungsgemäßes Verfahren zur Strukturierung von Metall-Keramik-Substraten

In einem weiteren Aspekt betrifft die vorliegende Erfindung ein Verfahren zur Herstellung eines strukturierten oben beschriebenen Metall-Keramik-Substrats.

Das erfindungsgemäße Verfahren ist zunächst einmal dadurch gekennzeichnet, dass ein wie oben beschriebenes Metall-Keramik-Substrat eingesetzt und einer Strukturierung durch direkte Belichtung unterworfen wird. Die Verwendung eines Direktbelichtungssystems verzichtet auf die Verwendung eines Films, wie in der Fotolithographie, und erzeugt Licht auf diejenigen Stellen, die einer Strukturierung unterworfen werden sollen.

Die Strukturierung auf der Metallbeschichtung selbst kann durch ein Direktbelichtungsverfahren mittels Laserstrahlung oder Projektoren erfolgen. Der Projektor projiziert dabei einen Teil des Bildes und scannt die gesamte Fläche ab, wodurch sich das gesamte Bild ergibt.

Erfindungsgemäß geeignete Vorrichtungen zur Direktbelichtung umfassen üblicherweise eine Belichtungskammer mit mindestens einer Kantenbilderfassungseinheit, mindestens einer Belichtungseinheit und mindestens einem Objektträger, auf welchem das Metall-Keramik-Substrat vorliegt.

Im Rahmen der vorliegenden Erfindung wird unter einer Belichtungskammer ein Raum verstanden, welcher mindestens einen Objektträger, eine Kantenbilderfassungseinheit und eine Belichtungseinheit aufweist.

Die Kantenbilderfassungseinheit ist eine Einheit, die in der Lage ist, die Position einer Kante des Metall-Keramik-Substrats zu erfassen.

Die Belichtungseinheit ist eine Einheit, die in der Lage ist, ein Metall-Keramik-Substrat derart zu Belichten, dass eine Strukturierung auf der Metallbeschichtung erzeugt wird.

Der Objektträger dient zur Fixierung des Metall-Keramik-Substrats und kann beweglich ausgebildet sein.

Die Lage des erfindungsgemäßen Metall-Keramik-Substrats in der Belichtungskammer auf dem Objektträger wird anhand der Lage mindestens
(1) zweier metallfreier Bezugskanten, die im Wesentlichen senkrecht zueinander verlaufen (vgl. erste Ausführungsform des erfindungsgemäßen Metall-Keramik-Substrats)
(2) einer metallfreier Bezugskante und eines Bezugspunktes in einem Teilbereich der Kante im Wesentlichen senkrecht zur Bezugskante (vgl. zweite Ausführungsform des erfindungsgemäßen Metall-Keramik-Substrats) oder
(3) zweier Referenzpunkte in metallfreien Teilbereichen einer ersten Kante unter Ausbildung einer Bezugskante und eines Bezugspunktes in einem metallfreien Teilbereich an einer Kante im Wesentlichen senkrecht zu der Bezugskante (vgl. dritte Ausführungsform des erfindungsgemäßen Metall-Keramik-Substrats)
bestimmt.

Erfindungsgemäß ist dabei vorgesehen, dass die Kantenerfassung auf die Keramikkante gerichtet ist und nicht auf die Kante der Metallbeschichtung, da sich diese während des erfindungsgemäßen Verfahrens durch Strukturierung verändern kann.

Die Lage der oben beschriebenen Kanten oder Punkte werden mit einer Bilderfassungseinheit identifiziert. Dabei kann jede Kante bzw. Punkt mit einer einzelnen Kamera oder aber zwei Punkte oder alle Kanten und Punkte können gemeinsam durch eine einzige Kamera identifiziert werden. Im Rahmen der vorliegenden Erfindung ist die Verwendung von separaten Kameras bevorzugt, da die Verwendung einer einzigen Kamera die entsprechenden Punkte zur Kantenerfassung sehr nahe zusammen liegen müssen, was aufgrund der Extrapolation der Daten zu Nachteilen führt, oder aber es muss ein sehr großes Kamerafeld verwendet werden, was zu einer Verschlechterung der Bildqualität und somit der Genauigkeit führen würde.

Alternativ ist in allen Ausführungsformen der vorliegenden Erfindung möglich, dass nur eine einzige Kamera zur Lageerkennung des Metall-Keramik-Substrats in der Belichtungskammer verwendet wird und die relative Position von Metall-Keramik-Substrat zu Kamera entweder durch Verschieben der Kamera oder durch Verschieben des Metall-Keramik-Substrats verändert wird; diese Ausführungsform weist den Vorteil auf, dass nur eine Kamera verwendet werden muss, führt allerdings gleichzeitig zu einer Verlangsamung des erfindungsgemäßen Verfahrens aufgrund der erforderlichen Relativverschiebung.

Die Genauigkeit der Positionsbestimmung des Metall-Keramik-Substrats in der Belichtungskammer kann durch die Bestimmung der Lage weiterer Bezugspunkte auf dem Keramiksubstrat verbessert werden. Daher weist das erfindungsgemäße Metall-Keramik-Substrat in einer weiteren Ausgestaltung weitere metallfreie Bereiche auf, durch dessen Lage die Position des Metall-Keramik-Substrats mitbestimmt werden kann. Diese weiteren metallfreien Kantenbereiche können auf denselben ersten und zweiten Kanten (vgl. die oben beschriebenen ersten bis dritten Ausführungsformen) oder an den anderen beiden Kantenliegen.

Zum Erfassen der Lage des Metall-Keramik-Substrats auf dem Objektträger wird eine Kantenerfassungseinheit verwendet. Diese Kantenerfassungseinheit umfasst mindestens eine, beispielsweise in dem Objektträger unter der Objektträgerfläche angeordnete, Kantenbeleuchtungsvorrichtung.

Diese Kantenbeleuchtungsvorrichtung ermöglicht in mindestens einem Kantenbereich des Metall-Keramik-Substrats die Ausbildung eines Beleuchtungsbereichs. Insbesondere ist die Beleuchtungseinheit so ausgebildet, dass sie alle diejenigen Bereiche der metallfreien Kante des Keramiksubstrats beleuchtet, die zur Bestimmung der Position des Metall-Keramik-Substrats herangezogen werden. In diesen Bereichen erfolgt ein Anleuchten mit flächenhaft abgestrahltem Licht. Gegebenenfalls kann es erforderlich sind, mehrere Kantenbeleuchtungsvorrichtungen für die unterschiedlichen metallfreien Bereiche des Metall-Keramik-Substrats zu verwenden.

Um die Erfassung der Kanten des Metall-Keramik-Substrats möglichst einfach zu gestalten, ist vorzugsweise vorgesehen, dass für jede Kante des Metall-Keramik-Substrats ein eigener Beleuchtungsbereich zum Anleuchten dieser Kante vorgesehen ist.

Im Abstand von der Objektträgerfläche, auf welcher das Metall-Keramik-Substrat platziert ist, und der der Beleuchtungsvorrichtung gegenüberliegenden Seite ist mindestens eine Kantenbilderfassungseinheit vorgesehen, welche einen in dem Beleuchtungsbereich liegenden Kantenabschnitt des Metall-Keramik-Substrats identifiziert und die Kantenabschnitt positionsgenau relativ zum Objektträger erfasst.

Grundsätzlich reicht mindestens eine Lichtquelle aus, die flächenhaft Licht abstrahlt. Eine vorteilhafte Lösung sieht vor, dass die Beleuchtungseinheit zur Ausleuchtung des jeweiligen Beleuchtungsbereichs einen Diffusor und mindestens eine diesen anleuchtende Lichtquelle aufweist.

Eine besonders einfache Art und Weise der Integration der Beleuchtungseinheit in die Direktbelichtungsvorrichtung sieht vor, dass die Lichtquellen und der Diffusor in dem Objektträger des Metall-Keramik-Substrats integriert sind.

Eine weitere vorteilhafte Lösung sieht vor, dass der Objektträger eine Objektträgerfläche bildende Objektträgerplatte aufweist und dass das Licht aus der Beleuchtungseinheit durch die Objektträgerplatte hindurchtritt.

Darüber hinaus ist es möglich, dass die Objektträgerplatte als optischer Diffusor wirkt, das heißt zusätzlich zur Aufnahme des Objekts auch noch den optischen Diffusor darstellt.

Die in dem erfindungsgemäßen Verfahren verwendete Kantenbilderfassungseinheit umfasst vorzugsweise ein telezentrisches Objektiv, das eine optische Achse aufweist, die maximal um 5° von einer Senkrechten zur Objektträgerebene abweicht. Hierdurch werden fehlerhafte Kantenbilder durch schräg verlaufende Kantenflächen vermieden.

Die Lage der Bezugskante, Bezugspunkte bzw. Referenzpunkte auf dem erfindungsgemäßen Metall-Keramik-Substrat können mit einer einzigen Kamera oder aber mit mehreren Kameras erfasst werden. Besonders wirtschaftlich ist, wenn die Lage der jeweiligen Kanten und Punkte mit einer einzigen Kamera erfasst werden kann.

Außerdem können zum Ableiten bzw. Errechnen eines Punktes oder einer Kante mehrere Punkte aufgenommen und diese mathematisch zu einem zusammengefasst werden. Hieraus ergeben sich beliebig kombinierbare Ausführungsformen der vorliegenden Erfindung.

Weitere genauere Ausgestaltung der Direktbelichtungsvorrichtung können der DE 10 2009 032 210 A entnommen werden.

Nach der Bestimmung der Position des Metall-Keramik-Substrats in der Belichtungskammer erfolgt die Strukturierung des Metall-Keramik-Substrats durch Belichtung im Wesentlichen senkrecht zu dem Metall-Keramik-Substrat von der gleichen Seite wie die Kantenerfassung oder aber von beiden Seiten gleichzeitig. Dabei können bei einem beidseitig metallbeschichteten Substrat die beiden zu strukturierenden Metallbeschichtungen gleichzeitig oder nacheinander durch Belichtung strukturiert werden. Bei einer gleichzeitigen Belichtung der beiden Seiten des Keramiksubstrats ist ein Objektträger erforderlich, der eine gleichzeitige Belichtung und Strukturierung von beiden Seiten ermöglicht.

Während der Bestimmung der Position des Metall-Keramik-Substrats in der Belichtungskammer und der anschließenden Strukturierung ist das Metall-Keramik-Substrat vorzugsweise fixiert.

Wie bereits ausgeführt, weisen DCB-Substrate herstellungsbedingt üblicherweise eine Durchbiegung auf. Diese Durchbiegung muss während des Belichtens so weit wie möglich reduziert werden, weil es andernfalls zu Fehlern bei der Bildverarbeitung bei der Kantenfindung (Unschärfe) und einer unscharfen Belichtung kommen kann. Erfindungsgemäß wurde daher für die einzusetzenden Metall-Keramik-Substrate eine maximal zulässige Ebenheit definiert.

Damit diese Ebenheit während des Prozesses der Kantenerfassung und der Strukturierung durch Belichtung eingehalten wird, sind die folgenden bereits beschriebenen Ausgestaltungen in dem erfindungsgemäßen Verfahren möglich:
Eine erste Möglichkeit, um eine entsprechende Durchbiegung der Metall-Keramik-Substrate während der Kantenerfassung und Strukturierung durch Belichtung zu vermeiden, ist die Fixierung des Metall-Keramik-Substrats zwischen zwei transparenten Platten oder Folien, beispielsweis zwischen zwei Glasplatten. Nachteilig an dieser ersten Möglichkeit ist die Bruchgefahr von Glas und Keramik sowie die Gefahr von Verkürzungen, was wiederum zu Fehlbelichtung führt. Ein weiterer Nachteil ist das anhaften von Verunreinigungen und Rückständen.

Eine zweite Möglichkeit, um eine entsprechende Durchbiegung der Metall-Keramik-Substrate während der Kantenerfassung und Strukturierung durch Belichtung zu vermeiden, ist das Einspannen oder Einklemmen der Substrate in einen Rahmen. Dieses birgt jedoch das Risiko von mechanischen Beschädigungen an den Keramik-Substraten. Außerdem können die Rahmen je nach Gestaltungsform die Kanten der Substrate ganz oder teilweise abdecken, was zu Einschränkungen während der Kantenfindung führen oder dieses ganz verhindern kann. Darüber hinaus wird gegebenenfalls die mögliche Fläche einer Strukturierung durch den Rahmen eingeschränkt.

Eine dritte Möglichkeit, um eine entsprechende Durchbiegung der Metall-Keramik-Substrate während der Kantenerfassung und Strukturierung durch Belichtung zu vermeiden, ist die Substrate mittels Vakuum anzusaugen. Das Niederspannen in den oben beschriebenen Ausführungsformen übt dabei eine mechanische Belastung auf das Grundmaterial aus (z.B. punktuelle Belastung einer Keramikecke). Dies führt dazu, dass sich beispielsweise Keramikpartikel von dem Belichtungsgut während des Niederspannvorgangs lösen und anschließend in dem Spannsystem verbleiben. Der Partikel kann dann bei folgenden Belichtungszyklen sich beispielsweise in der Maske mechanisch verankern und somit zu seriellen Fehlbelichtung führen. Sollte es sich um größere Partikel handeln, kann sogar mit einer irreparablen Schädigung (Mikrorisse in der Keramik; mechanische Abdrücke Metall) des Belichtungsguts gerechnet werden.

Nachteilig an dieser dritten Verfahrensweise ist, dass eine beidseitige gleichzeitige Belichtung verhindert wird. Daher ist in dieser Ausführungsform ein zweiter Belichtungsschritt für die Rückseite des Metall-Keramik-Substrats erforderlich, der ein präzises ausrichten an einer Keramikkante umso wichtiger macht, damit eine möglichst hohe Positionsgenauigkeit zwischen dem Layout auf der Vorderseite und der Rückseite realisiert werden kann. Hierbei ist außerdem darauf zu achten, dass nach dem Wenden des Substrats dieselbe Keramikkante erfasst werden muss. Je nachdem, ob über die lange oder kurze Substratkante gekippt wird, muss bei der einen oder der anderen Kante die Position der Bildverarbeitung angepasst werden.

Daher wird im Rahmen der vorliegenden Erfindung in einer weiteren Ausführungsform die Verwendung von erhöhten Belichtungsnestern vorgeschlagen, die aus einem weichem Grundmaterial bestehen, beispielsweise einem Gummimetrial, wie Linatex^{®}, oder einen Schaumstoffmaterial, durch welche der entstandene Partikel nach dem Niederspannungsvorgang nahezu nicht wieder auf das Belichtungsgut bzw. auf die Spannvorrichtung gelangen kann. Der Partikel verbleibt somit in einem unkritischen Bereich außerhalb des Spannsystems und kann später einfach entfernt werden. Belichtungsfehler werden somit wirkungsvoll minimiert. Sollte es wider Erwarten dennoch zu einem Partikel zwischen Spannvorrichtung und Belichtungsgut kommen, kann eine mechanische Beschädigung des Substrats nahezu ausgeschlossen werden, da sich der Partikel beim Spannvorgang in das weiche Nest drücken kann und nicht zwangsläufig in die Substratoberfläche gedrückt wird.

Eine punktuelle Belastung des Ecken- der Kantenbereichs kann derart entgegengewirkt werden, in dem die Spannvorrichtung eine kleinere Grundfläche aufweist als das zu belichtende Metall-Keramik-Substrat. Somit würde das Niederspannsystem den Randbereich des Metall-Keramik-Substrats nicht direkt mechanisch beeinflussen. Das Metall-Keramik-Substrat ragt somit über das Spannsystem hinaus.

Das erfindungsgemäß vorgesehene Belichtungsnest weist in dem weichen Grundmaterial Löcher oder Kapillare auf, durch welche ein Vakuum auf das Metall-Keramik-Substrat ausgeübt werden kann. Durch Anlagen des Vakuums kommt es dann zu einem Niederspannen des Metall-Keramik-Substrats.

Zusammenfassend umfasst das erfindungsgemäße Verfahren daher insbesondere die folgenden Verfahrensschritte:
(a) Bereitstellen eines Metall-Keramik-Substrats auf einem Objektträger in einer Direktbelichtungsvorrichtung;
(b) Erkennen der Position des zu strukturierende Metall-Keramik-Substrats auf dem Objektträger in der Belichtungskammer; und
(c) Belichtung der metallischen Beschichtung des Metall-Keramik-Substrats.

Das erfindungsgemäße Verfahren kann in einer Belichtungskammer durchgeführt werden, dessen Objektträger so ausgebildet ist, dass mindestens 2 Metall-Keramik-Substrate, weiter bevorzugt mindestens 4 Metall-Keramik-Substrate, noch weiter bevorzugt mindestens 6 Metall-Keramik-Substrate, noch weiter bevorzugt mindestens 8 Metall-Keramik-Substrate, auf dem Objektträger fixiert vorliegen und gleichzeitig durch Direktbelichtung strukturiert werden können.

Zum Belichten des Metall-Keramik-Substrats ist es des Weiteren bevorzugt, wenn das Metall-Keramik-Substrat niedergespannt wird und damit eine ausreichende Ebenheit aufweist. Dieses Niederspannen kann beispielsweise mit einer speziellen Objektträgeranordnung erreicht werden.

Die vorliegende Erfindung wird anhand der nachfolgenden näher erläuterten Figurenbe-schreibung näher erläutert.

Die vorliegende Erfindung wird anhand der nachfolgenden Figuren näher erläutert:
Die Figuren 1 bis 3 zeigen Ausgestaltungen des erfindungsgemäßen Metall-Keramik-Substrats, die bereits vorstehend näher erläutert wurden.
Die Figur 4 verdeutlicht das erfindungsgemäße Verständnis der Ebenheit. Zur Definition der Ebenheit wird auf obige Ausführungen verwiesen.
Die Figur 5 zeigt verschiedene Durchbiegungsausrichtungen von üblichen Metall-Keramik-Substraten.

## Patentansprüche

1. Metall-Keramik-Substrat, bei welchem auf einem im Wesentlichen rechteckigen Keramik-Substrat mindestens eine Metallschicht vorgesehen ist, wobei das Keramik-Substrat zumindest teilweise im Kantenbereich frei von metallischer Beschichtung ist, flächig ausgebildet ist und die darauf vorgesehene flächige Metallschicht sich zumindest teilweise nicht bis zur Kante des flächigen Keramik-Substrats erstreckt und somit zumindest der teilweise metallfreier Kantenbereich gebildet wird und der Kantenbereich, der frei von einer Metallisierung ist, sich lateral bis zu einer gedachten Parallelen zu der Keramikkante erstreckt, wobei der Abstand der gedachten Parallelen zu der Keramikkante maximal 1,5 cm beträgt, **dadurch gekennzeichnet, dass** das Metall-Keramik-Substrat ein DCB-Substrat ist und eine Ebenheit von kleiner als 1600 µm aufweist, wobei unter der Ebenheit des Metall-Keramik-Substrats eine Formtoleranz des Metall-Keramik-Substrats verstanden wird, in der sich die ebene Fläche des Metall-Keramik-Substrats befinden muss, die Toleranzgrenzen sich durch zwei gedachte Flächen parallel zur ideal planaren Fläche des Metall-Keramik-Substrats ergeben, wobei in dem Fall, in welchem die real erzeugte Fläche des Metall-Keramik-Substrats durch die eine der parallelen Flächen durchsticht, die Toleranz überschritten ist und die Toleranz den Abstand der beiden gedachten parallelen Flächen angibt und wobei die Fläche des Keramik-Substrats 5 x 10 cm bis 16 x 21 cm beträgt.

2. Metall-Keramik-Substrat nach Anspruch 1, **dadurch gekennzeichnet, dass** in dem metallfreien Kantenbereich die Metallbeschichtung im Wesentlichen parallel zur Keramikkante verläuft und einen Abstand von mindestens 0,1 cm von der Keramikkante aufweist.

3. Metall-Keramik-Substrat nach einem der Ansprüche 1 oder 2, **dadurch gekennzeichnet, dass** in dem Metall-Keramik-Substrat zwei im Wesentlichen senkrecht zueinander angeordnete Kanten metallfrei ausgebildet sind.

4. Metall-Keramik-Substrat nach einem der Ansprüche 1 oder 2, **dadurch gekennzeichnet, dass** eine Kante des Metall-Keramik-Substrats metallfrei ausgebildet ist und die Kante senkrecht zu dieser Kante des Metall-Keramik-Substrats einen Teilbereich aufweist, der ebenfalls metallfrei ausgebildet ist.

5. Metall-Keramik-Substrat nach einem der Ansprüche 1 oder 2, **dadurch gekennzeichnet, dass** das Metall-Keramik-Substrat an einer ersten Kante zwei metallfreie Teilbereiche aufweist und an einer Kante, die senkrecht zu der ersten Kante verläuft, einen weiteren metallfreien Teilbereich aufweist.

6. Verfahren zur Herstellung eines strukturierten Metall-Keramik-Substrats, **dadurch gekennzeichnet, dass** die Strukturierung der Metallschicht auf dem Substrat durch ein Direktbelichtungsverfahren erfolgt und ein Metall-Keramik-Substrat gemäß einem der Ansprüche 1 bis 5 verwendet wird.

7. Verfahren nach Anspruch 6, **dadurch gekennzeichnet, dass** das Direktbelichtungsverfahren mit einer Direktbelichtungsvorrichtung durchgeführt wird, die eine Belichtungskammer, umfassend mindestens eine Kantenbilderfassungseinheit, mindestens eine Belichtungseinheit und mindestens einen Objektträger, auf welchem das Metall-Keramik-Substrat vorliegt, aufweist.

8. Verfahren nach Anspruch 6 oder 7, **gekennzeichnet durch** die folgenden Verfahrensschritte:
a. Bereitstellen eines Metall-Keramik-Substrats auf einem Objektträger in einer Direktbelichtungsvorrichtung;
b. Erkennen der Position des zu strukturierende Metall-Keramik-Substrats auf dem Objektträger in der Belichtungskammer; und
c. Belichtung der metallischen Beschichtung des Metall-Keramik-Substrats.

9. Verfahren nach Anspruch 8, **dadurch gekennzeichnet, dass** die Direktbelichtungsvorrichtung so ausgebildet ist, dass sie die Lage des zu strukturierenden Substrats auf dem Objektträger in der Belichtungskammer anhand der Lage von Kanten oder Punkten an der oder den metallfreien Kante(n) des Keramiksubstrats erkennt.

10. Verfahren nach einem der Ansprüche 6 bis 9, **dadurch gekennzeichnet, dass** die Lage des Metall-Keramik-Substrats anhand zweier metallfreier Kanten, die im Wesentlichen senkrecht zueinander verlaufen, erfolgt.

11. Verfahren nach einem der Ansprüche 6 bis 9, **dadurch gekennzeichnet, dass** die Lage des Metall-Keramik-Substrats anhand einer metallfreien Kante und eines Bezugspunktes in einem metallfreien Teilbereich der Kante im Wesentlichen senkrecht zur Bezugskante erfolgt.

12. Verfahren nach einem der Ansprüche 6 bis 9, **dadurch gekennzeichnet, dass** die Lage des Metall-Keramik-Substrats anhand zweier Punkte in metallfreien Teilbereichen einer ersten Kante und eines Punktes in einem metallfreien Teilbereich an einer Kante im Wesentlichen senkrecht zu der ersten Kante erfolgt.

13. Verwendung von Metall-Keramik-Substraten gemäß einem der Ansprüche 1 bis 5 in einem Verfahren zur Strukturierung der Metallbeschichtung(en) des Keramiksubstrats.

## Claims

1. Metal-ceramic substrate, in which at least one metal layer is provided on a substantially rectangular ceramic substrate, wherein the ceramic substrate is at least partially free of metallic coating in the edge region, is surface-like in shape, and the metal layer provided thereon does not extend at least partially to the edge of the surface-like ceramic substrate and thus at least the partially metal-free edge region is formed and the edge region, which is free from metallization, extends laterally to an imaginary parallel to the ceramic edge, wherein the distance of the imaginary parallel to the ceramic edge is at most 1.5 cm, **characterized in in that** the metal-ceramic substrate is a DCB substrate and has a flatness of less than 1600 µm, wherein the flatness of the metal-ceramic substrate is understood to mean a shape tolerance of the metal-ceramic substrate in which the flat surface of the metal-ceramic substrate must be located, the tolerance limits resulting from two imaginary surfaces parallel to the ideally planar surface of the metal-ceramic substrate, wherein in the case in which the actually produced surface of the metal-ceramic substrate pierces through one of the parallel surfaces, the tolerance is exceeded and the tolerance indicates the distance between the two imaginary parallel surfaces and wherein the surface of the ceramic substrate is 5 x 10 cm to 16 x 21 cm.

2. Metal-ceramic substrate according to claim 1, **characterized in that** in the metal-free edge region the metal coating runs essentially parallel to the edge of the ceramic and has a distance of at least 0.1 cm from the edge of the ceramic.

3. Metal-ceramic substrate according to one of claims 1 or 2, **characterized in that** in the metal-ceramic substrate two edges arranged essentially perpendicular to each other are formed metal-free.

4. Metal-ceramic substrate according to one of claims 1 or 2, **characterized in that** one edge of the metal-ceramic substrate is formed metal-free and the edge perpendicular to this edge of the metal-ceramic substrate has a partial region which is also formed metal-free.

5. Metal-ceramic substrate according to one of claims 1 or 2, **characterized in that** the metal-ceramic substrate has two metal-free partial regions at a first edge and has a further metal-free partial region at an edge which runs perpendicular to the first edge.

6. Process for producing a structured metal-ceramic substrate, **characterized in that** the structuring of the metal layer on the substrate is carried out by a direct exposure process and a metal-ceramic substrate according to one of claims 1 to 5 is used.

7. Process according to claim 6, **characterized in that** the direct exposure process is carried out with a direct exposure device which has an exposure chamber comprising at least one edge image acquisition unit, at least one exposure unit and at least one object carrier on which the metal-ceramic substrate is present.

8. Process according to claim 6 or 7, **characterized by** the following process steps:
a. Providing a metal-ceramic substrate on an object carrier in a direct exposure device;
b. Detecting the position of the metal-ceramic substrate to be structured on the object carrier in the exposure chamber; and
c. Exposing the metallic coating of the metal-ceramic substrate.

9. Process according to claim 8, **characterized in that** the direct exposure device is designed in such a way that it detects the position of the substrate to be structured on the object carrier in the exposure chamber by means of the position of edges or points on the metal-free edge or edges of the ceramic substrate.

10. Process according to one of claims 6 to 9, **characterized in that** the position of the metal-ceramic substrate is carried out by means of two metal-free edges which are substantially perpendicular to each other.

11. Process according to one of claims 6 to 9, **characterized in that** the position of the metal-ceramic substrate is carried out by means of a metal-free edge and a reference point in a metal-free subregion of the edge substantially perpendicular to the reference edge.

12. Process according to one of claims 6 to 9, **characterized in that** the position of the metal-ceramic substrate is carried out by means of two points in metal-free subregions of a first edge and a point in a metal-free subregion at an edge substantially perpendicular to the first edge.

13. Use of metal-ceramic substrates according to one of claims 1 to 5 in a process for structuring the metal coating(s) of the ceramic substrate.

## Revendications

1. Substrat métal-céramique, dans lequel au moins une couche métallique est prévue sur un substrat céramique essentiellement rectangulaire, dans lequel le substrat céramique est au moins partiellement exempt de revêtement métallique dans la zone de bord, est réalisé d'une manière surfacique et la couche métallique surfacique prévue sur celui-ci ne s'étend pas, au moins en partie, jusqu'au bord du substrat céramique surfacique et ainsi, au moins la zone de bord partiellement exempte de métal est formée et la zone de bord, qui est exempte de métallisation, s'étend latéralement jusqu'à une parallèle imaginaire au bord céramique, dans lequel la distance des parallèles imaginaires au bord céramique est au maximum de 1,5 cm, **caractérisé en ce que** le substrat métal-céramique est un substrat DCB et présente une planéité inférieure à 1600 µm, dans lequel la planéité du substrat métal-céramique est entendue comme une tolérance de forme du substrat métal-céramique dans laquelle doit se trouver la surface plane du substrat métal-céramique, les limites de tolérance sont obtenues par deux surfaces imaginaires parallèles à la surface idéalement plane du substrat métal-céramique, dans lequel, dans le cas où la surface réellement produite du substrat métal-céramique perce l'une des surfaces parallèles, la tolérance est dépassée et la tolérance indique la distance entre les deux surfaces parallèles imaginaires et dans lequel la surface du substrat céramique est de 5 x 10 cm à 16 x 21 cm.

2. Substrat métal-céramique selon la revendication 1, **caractérisé en ce que** le revêtement métallique s'étend essentiellement parallèlement au bord céramique dans la zone de bord exempte de métal et présente une distance d'au moins 0,1 cm par rapport au bord céramique.

3. Substrat métal-céramique selon l'une des revendications 1 ou 2, **caractérisé en ce que**, dans le substrat métal-céramique, deux arêtes disposées sensiblement perpendiculairement l'une à l'autre sont exemptes de métal.

4. Substrat métal-céramique selon l'une des revendications 1 ou 2, **caractérisé en ce qu'**un bord du substrat métal-céramique est exempt de métal et **en ce que** le bord perpendiculaire à ce bord du substrat métal-céramique présente une zone partielle qui est également exempte de métal.

5. Substrat métal-céramique selon l'une des revendications 1 ou 2, **caractérisé en ce que** le substrat métal-céramique présente deux zones partielles exemptes de métal sur un premier bord et présente une autre zone partielle exempte de métal à un bord qui s'étend perpendiculairement au premier bord.

6. Procédé de fabrication d'un substrat métal-céramique structuré, **caractérisé en ce que** la structuration de la couche métallique sur le substrat est réalisée par un procédé d'exposition directe et **en ce que** l'on utilise un substrat métal-céramique selon l'une des revendications 1 à 5.

7. Procédé selon la revendication 6, **caractérisé en ce que** le procédé d'exposition directe est mis en oeuvre avec un dispositif d'exposition directe qui présente une chambre d'exposition comprenant au moins une unité de détection d'image de bord, au moins une unité d'exposition et au moins un porte-objet sur lequel le substrat métal-céramique est présent.

8. Procédé selon la revendication 6 ou 7, **caractérisé par** les étapes de procédé suivantes :
a. Mettre à disposition d'un substrat métal-céramique sur un porte-objet dans un dispositif d'exposition directe ;
b. Détecter la position du substrat métal-céramique à structurer sur le porte-objet dans la chambre d'exposition ; et
c. Exposition du revêtement métallique du substrat métal-céramique.

9. Procédé selon la revendication 8, **caractérisé en ce que** le dispositif d'exposition directe est conçu de manière à détecter la position du substrat à structurer sur le porte-objet dans la chambre d'exposition sur la base de la position des bords ou des points sur le ou les bords non métalliques du substrat céramique.

10. Procédé selon l'une des revendications 6 à 9, **caractérisé en ce que** la position du substrat métal-céramique est effectuée sur la base de deux bords exempts de métal qui sont essentiellement perpendiculaires entre eux.

11. Procédé selon l'une des revendications 6 à 9, **caractérisé en ce que** la position du substrat métal-céramique est effectuée sur la base d'un bord exempt de métal et d'un point de référence dans une zone partielle exempte de métal du bord essentiellement perpendiculaire au bord de référence.

12. Procédé selon l'une des revendications 6 à 9, **caractérisé en ce que** la position du substrat métal-céramique est effectuée sur la base de deux points dans des zones exemptes de métal d'un premier bord et d'un point dans une zone exempte de métal sur un bord essentiellement perpendiculaire au premier bord.

13. Utilisation de substrats métal-céramique selon l'une des revendications 1 à 5 dans un procédé de structuration du ou des revêtements métalliques du substrat céramique.
